# EUROPEAN PATENT APPLICATION

(11) **EP 2 587 557 A1**
(43) Date of publication of application: **01.05.2013**
(21) Application number: 11797552.4
(22) Date of filing: 21.05.2011
(51) Int. Cl.: H01L 33/48, H01L 33/56

(54) **LIGHT EMITTING DIODE PACKAGING STRUCTURE AND MANUFACTURING METHOD THEREOF**

(30) Priority: 23.06.2010 CN 201010207018
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074479
(87) International publication number: WO 2011/160521

(57) **Abstract**

A light emitting diode (LED) packaging structure includes a substrate, a first transparent plastic layer, a second transparent plastic layer, an LED chip, fluorescent glue covering the LED chip and packaging plastic covering the substrate, the first transparent plastic layer and the fluorescent glue. The first and second transparent plastic layers are provided on the substrate. The LED chip is provided in the first enclosed flat pattern and the second enclosed flat pattern encloses the second transparent plastic layer. The first transparent plastic layer is higher than the LED chip and the second transparent plastic layer is higher than the first transparent plastic layer. The LED packaging structure does not require a leadframe and provides a broad emission angle of light.

## Description

### BACKGROUND OF THE INVENTION

### 1. Field of the Invention

The present invention generally relates to a light emitting diode (LED) packaging structure and manufacturing method thereof, and more specifically to an LED packaging structure using the transparent plastic layer and the packaging plastic to increase the emission angle and smooth the emitting light without a leadframe.

### 2. The Prior Arts

With excellent light emitting, low power consumption and long lifetime, an LED has become one the most important light source to replace the traditional incandescent light bulb to meet the world wide trend for power saving and carbon reduction.

In general, the LED packaging structure in the prior arts uses the leadframe to support the LED chip and provides heat dissipation path to propagate the heat generated by the LED chip to an external heat dissipation device, such as aluminum heat sink or other heat dissipation fin. The light emitted by the LED will deteriorate over time due to much higher working temperature for the LED. Therefore, it is a key solution for the LED packaging industries to reduce the working temperature of the LED.

However, one of the shortcomings in the prior arts is that the leadframe has poor thermal transfer property for heat dissipation such that the effect of reducing the working temperature of the LED is greatly limited. The size of the traditional aluminum heat sink is relatively large. As a result, it is inconvenient to use in actual applications and the cost is increased. Additionally, the leadframe is usually not transparent and part of the light from the LED will be blocked such that the emission angle is constrained. Therefore, it is desired to provide a new LED packaging structure without the leadframe to overcome the above problems in the prior arts.

### SUMMARY OF THE INVENTION

Therefore, the present invention has been made in view of the above problems, and it is an objective of the present invention to provide a packaging structure, which comprises a substrate, a first transparent plastic layer having a first enclosed flat pattern, a second transparent plastic layer having a second enclosed flat pattern, an LED chip, fluorescent glue covering the LED chip and packaging plastic covering the substrate, the first transparent plastic layer and the fluorescent glue. The first and second transparent plastic layers are provided on the substrate. The LED chip is provided in the first enclosed flat pattern and the second enclosed flat pattern encloses the second transparent plastic layer. The first transparent plastic layer is higher than the LED chip and the second transparent plastic layer is higher than the first transparent plastic layer.

Therefore, the above LED packaging structure provides a broad emission angle without the traditional leadframe so as to simplify the whole structure and improve the efficiency of light emission.

Another objective of the present invention to provide a method of manufacturing an LED packaging structure, which includes the steps of: coating two transparent materials on a substrate to form at least one first transparent plastic layer and a second transparent plastic layer, respectively, with enclosed flat patterns; performing a first drying process to cure the first transparent plastic layer and the second transparent plastic layer; binding at least one LED chip to the substrate by sliver paste or a eutectic process such that the LED chip is provided on the substrate within the first enclosed flat pattern; coating a fluorescent glue to cover the LED chip; performing a second drying process to cure the fluorescent glue; coating a packaging plastic to cover the first transparent plastic layer, the fluorescent glue and the substrate, and finally performing a third drying process to cure the packaging plastic.

One aspect of the method of the present invention is that the enclosed flat pattern of the first transparent plastic layer after being cured serves as an enclosed wall to hold the fluid fluorescent glue before being cured without flowing out of the enclosed flat pattern, and the enclosed flat pattern of the second transparent plastic layer after being cured also serves as an enclosed wall to hold the fluid packaging plastic before being cure. Thus, the process flow of manufacturing the LED packaging structure is simplified, and meanwhile, the first and second transparent layers provide transparency to allow the light pass through such that the intensity of the light is greatly increased and the final output light is considerably improved.

### BRIEF DESCRIPTION OF THE DRAWINGS

The present invention can be understood in more detail by reading the subsequent detailed description in conjunction with the examples and references made to the accompanying drawings, wherein:

FIG. 1 is a schematic cross-section view showing an LED packaging structure according to the present invention; and

FIG. 2 is a flow diagram showing a method of manufacturing the LED packaging structure according to the present invention; and

FIGs. 3 and 4 are schematic views showing the processes of the method according to the present invention.

### DETAILED DESCRIPTION OF THE PREFERRED EMBODIMENTS

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

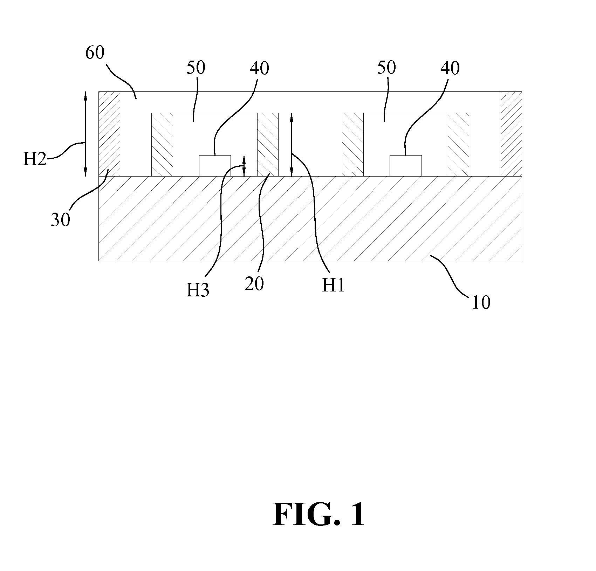

FIG. 1 is a schematic cross-section view showing an LED packaging structure according to the present invention. As shown in FIG. 1, the LED packaging structure of the present invention generally includes a substrate 10, at least one first transparent plastic layer 20, a second transparent plastic layer 30, at least one LED chip 40, a fluorescent glue 50 and a packaging plastic 60. The first transparent plastic layer 20 and the second transparent plastic layer 30 are provided on the substrate 10.

The substrate 10 is a ceramic substrate made from ceramic material, such as aluminum oxide.

Each first transparent plastic layer 20 has a first enclosed flat pattern with a first height H1, such as circle or rectangle. The second transparent plastic layer 30 has a second enclosed flat pattern with a second height H2, such as circle or rectangle. Specifically, the second height H2 is larger than the first height H1.

The LED chip 40 is bound to on the substrate 10 by sliver paste (not visible) or a eutectic process and in the respective first enclosed flat pattern. Each LED chip 40 has a third height H3 less than the first height H1.

The fluorescent glue 50 is provided within the first enclosed flat pattern of the first transparent plastic layer 20, and covers the LED chip 40 and portions of the substrate 20 within the first enclosed flat pattern. The height of the fluorescent glue 50 is greater than the third height H3 of the LED chip 40.

The packaging plastic 60 is provided in the second enclosed flat pattern of the second transparent plastic layer 30, and covers the first transparent plastic layer 20, the fluorescent glue 50 and portions of the substrate 20 out of the first enclosed flat pattern. The height of the packaging plastic 60 is greater than the first height H1 of the substrate 20.

The first transparent plastic layer 20 is made from a first transparent material and the second transparent plastic layer 30 is made from a second transparent material. The first transparent material and the second transparent material are the same or different. For example, the first transparent material and the second transparent material consists of silicone or epoxy resin. The fluorescent glue 50 consists of fluorescent powder and transparent resin. Specifically, the fluorescent powder is used to transform part of the light emitted by the LED chip 40 into visible light, and the transparent resin is transparent epoxy resin or silicon. Also, the packaging plastic 60 is epoxy resin or silicon to provide insulation and protection as well as high transparency. Additionally, the packaging plastic 60 can effectively smooth the light emission and increase the size of the original light from the LED chip 40 as a spot light source, which is approximately transformed into a large surface light source.

The curing temperature of the packaging plastic 60 is not greater than the curing temperature of the fluorescent glue 50, which is not greater than the curing temperature of the first transparent plastic layer 20 and the curing temperature of the second transparent plastic layer 30.

One aspect of the above LED packaging structure is that the first transparent plastic layer with high transparency can totally replace the traditional leadframe and enclose the fluorescent glue provided on the LED chip to increase the intensity and emission angle of the light.

Another aspect of the above LED packaging structure is that the packaging plastic covers the first transparent plastic layer and the fluorescent glue to provide second-round optical function such that the final output light is greatly improved and the original spot light source is approximately transformed into a large surface light source.

A yet aspect of the above LED packaging structure is that the second transparent plastic layer encloses the packaging plastic covering the fluorescent glue to provide support function and the second transparent plastic layer is transparent such that the light incident onto the second transparent plastic layer can pass through without blocking and the intensity of the final emitting light is improved.

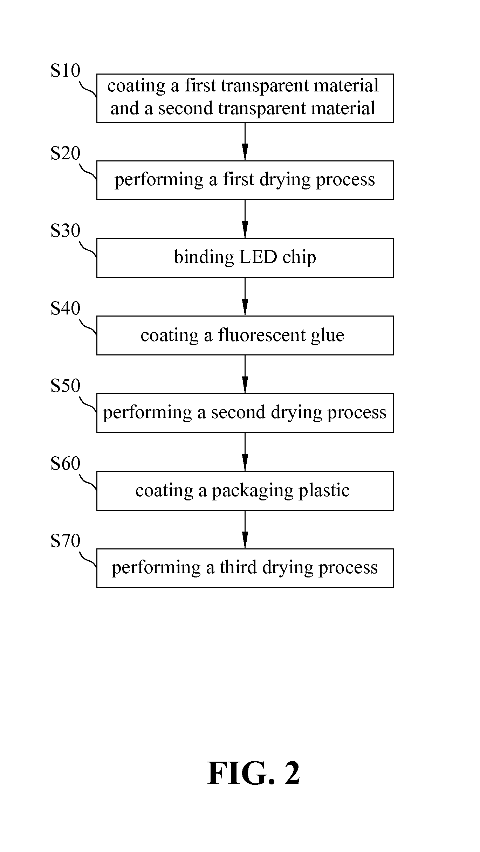

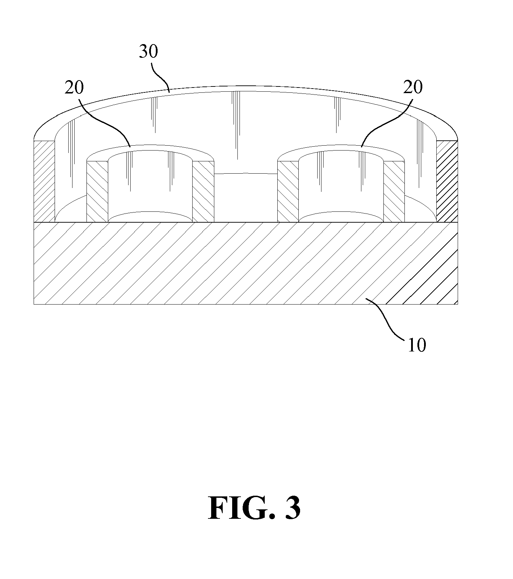

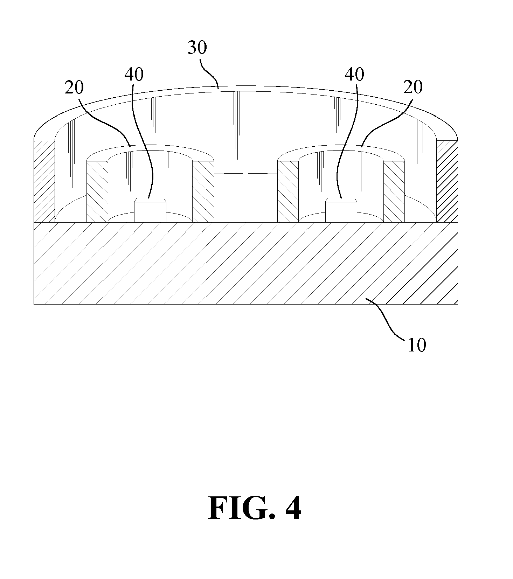

FIG. 2 is a flow diagram showing the method of manufacturing the LED packaging structure according to the present invention while FIGs. 3 and 4 are schematic views showing the processes of the method according to the present invention. As shown in FIGs. 2 and 3, the method of the present invention generally begins in the step S10 by coating a first transparent material and a second transparent material on a substrate 10 to form at least one first transparent plastic layer 20 and a second transparent plastic layer 30, respectively. Each first transparent plastic layer 20 has a first enclosed flat pattern and the second transparent plastic layer 30 has a second enclosed flat pattern.

Next, a first drying process is performed at the first curing temperature in the step 20 to cure the first transparent plastic layer 20 and the second transparent plastic layer 30. The first curing temperature is greater than the curing temperature of the first transparent plastic layer 20 and the curing temperature of the second transparent plastic layer 30. Preferably, the first curing temperature ranges from 110°C to 130°C.

In the step S30, as shown in FIG. 4, the LED chip 40 is disposed on the substrate 10, and more specifically, the LED chip 40 is bound to the substrate 10 by sliver paste or a eutectic process. As a result, the LED chip 40 is provided on the substrate 20 within the respective first enclosed flat pattern of the first transparent plastic layer 20.

Then, as shown in FIG. 1, the step S40 is performed by coating the fluorescent glue 50 to cover the LED chip 40 and portions of the substrate 10 within the first enclosed flat pattern, and in the step S50, a second drying process is performed at the second curing temperature to cure the fluorescent glue 50. The second curing temperature is greater than a curing temperature of the fluorescent glue 50, and more specifically, the second curing temperature ranges from 100°C to 220°C.

Subsequently, the step S60 is performed by coating the packaging plastic 60 to cover the first transparent plastic layer 20, the fluorescent glue 50 and portions of the substrate 10 within the second enclosed flat pattern, as shown in FIG. 1. Finally, in the step S70, a third drying process is performed at the third curing temperature to cure the packaging plastic 60. The third curing temperature is greater than the curing temperature of the packaging plastic 60. Preferably, the third curing temperature ranges from 100°C to 200°C.

It is noted that the a substrate 10, the first transparent plastic layer 20, the second transparent plastic layer 30, the LED chip 40, the fluorescent glue 50 and the packaging plastic 60 mentioned in the method of the present invention are similar to those of the LED packaging structure as shown in FIG 1. Thus, the detailed description for those elements is omitted.

One aspect of the method according to the present invention is that the enclosed flat pattern of the first transparent plastic layer after being cured serves as an enclosed wall to hold the fluid fluorescent glue before being cured without flowing out of the enclosed flat pattern. The curing temperature of the first transparent plastic layer is higher than the curing temperature of the fluorescent glue such that the first transparent plastic layer is not affected during the latter curing process of the fluorescent glue. Therefore, the first transparent plastic layer can totally replace the traditional leadframe.

Another aspect of the method is that the enclosed flat pattern of the second transparent plastic layer after being cured also serves as an enclosed wall to hold the fluid packaging plastic before being cured, and the curing temperature of the second transparent plastic layer is higher than the curing temperature of the packaging plastic such that the second transparent plastic layer is not affected during the latter curing process of the packaging plastic.

Furthermore, the process flow of the method is simplified, and the first and second transparent layers provide transparency to allow the light pass through such that the intensity of the light is greatly increased and the final output of light is considerably improved.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A light emitting diode (LED) packaging structure, comprising:
a substrate;
at least one first transparent plastic layer provided on the substrate, the first transparent plastic layer having a first enclosed flat pattern with a first height;
a second transparent plastic layer provided on the substrate, the second transparent plastic layer having a second enclosed flat pattern with a second height, which encloses the first transparent plastic layer;
at least one LED chip bound to on the substrate by sliver paste or a eutectic process in a respective first enclosed flat pattern, the LED chip having a third height;
a fluorescent glue consisting a fluorescent powder and a transparent resin, wherein the fluorescent glue is provided in the first enclosed flat pattern and covers the LED chip and portions of the substrate within the first enclosed flat pattern; and
a packaging plastic provided in the second enclosed flat pattern and covering the first transparent plastic layer and the substrate;
wherein, the second height is higher than the first height and the first height is higher than the third height.

2. The LED packaging structure as claimed in claim 1, wherein the first transparent plastic layer is made from a first transparent material consisting of silicone or epoxy resin, and the second transparent plastic layer is made from a second transparent material consisting of silicone or epoxy resin.

3. The LED packaging structure as claimed in claim 1, wherein the transparent resin of the fluorescent glue consists of silicone or transparent epoxy resin.

4. The LED packaging structure as claimed in claim 1, wherein the packaging plastic has a curing temperature not greater than a curing temperature of the fluorescent glue, the curing temperature of the fluorescent glue is not greater than a curing temperature of the first transparent plastic layer, and the curing temperature of the first transparent plastic layer is not greater than a curing temperature of the second transparent plastic layer.

5. A manufacturing method of an LED packaging structure, comprising steps of:
coating a first transparent material and a second transparent material on a substrate to form first and second transparent plastic layers, respectively, wherein the first transparent plastic layer has a first enclosed flat pattern and the second transparent plastic layer has a second enclosed flat pattern;
performing a first drying process at a first curing temperature to cure the first transparent plastic layer and the second transparent plastic layer, wherein the first curing temperature is greater than the curing temperature of the first transparent plastic layer and the curing temperature of the second transparent plastic layer;
binding at least one LED chip to the substrate by sliver paste or a eutectic process such that the LED chip is provided on the substrate within a respective first enclosed flat pattern;
coating a fluorescent glue to cover the LED chip and portions of the substrate within the first enclosed flat pattern;
performing a second drying process at a second curing temperature to cure the fluorescent glue, wherein the second curing temperature is greater than a curing temperature of the fluorescent glue;
coating a packaging plastic to cover the first transparent plastic layer, the fluorescent glue and portions of the substrate within the second enclosed flat pattern; and
performing a third drying process at a third curing temperature to cure the packaging plastic, wherein the third curing temperature is greater than a curing temperature of the packaging plastic.

6. The method as claimed in claim 5, wherein the first transparent plastic layer is made from a first transparent material consisting of silicone or epoxy resin, and the second transparent plastic layer is made from a second transparent material consisting of silicone or epoxy resin.

7. The method as claimed in claim 5, wherein the packaging plastic has a curing temperature not greater than a curing temperature of the fluorescent glue, the curing temperature of the fluorescent glue is not greater than a curing temperature of the first transparent plastic layer, and the curing temperature of the first transparent plastic layer is not greater than a curing temperature of the second transparent plastic layer.

8. The method as claimed in claim 5, wherein the first curing temperature ranges from 110°C to 130°C.

9. The method as claimed in claim 5, wherein the second curing temperature ranges from 100°C to 220°C.

10. The method as claimed in claim 5, wherein the third curing temperature ranges from 100°C to 200°C.
